# EUROPÄISCHE PATENTSCHRIFT

(11) **EP 0 995 821 B1**
(45) Veröffentlichungstag und Bekanntmachung des Hinweises auf die Patenterteilung: **13.06.2001**
(21) Anmeldenummer: 99117454.1
(22) Anmeldetag: 09.09.1999
(51) Int. Cl.: C30B 35/00

(54) **Verfahren und Vorrichtung zur Bearbeitung von Halbleitermaterial**
Method and apparatus for working semiconductor material
Procédé et dispositif pour le traitement de matériau semi-conducteur

(30) Priorität: 13.10.1998 DE 19847098
(43) Veröffentlichungstag der Anmeldung: 26.04.2000
(73) Patentinhaber: Wacker-Chemie GmbH, 81737 München (DE)
(72) Erfinder: Flottmann, Dirk, Dr., 84503 Altötting (DE); Ast, Gerhard, 84547 Emmerting (DE); Wolf, Reinhard, 84547 Emmerting (DE)
(74) Vertreter: Budczinski, Angelika

(56) Entgegenhaltungen:
- EP-A- 0 273 628
- EP-A- 0 856 599
- DE-A- 19 716 374
- US-A- 4 871 117
- PATENT ABSTRACTS OF JAPAN vol. 1996, no. 07, 31. Juli 1996 (1996-07-31) & JP 08 064662 A (NOMURA MICRO SCI CO LTD), 8. März 1996 (1996-03-08)

## Beschreibung

Die Erfindung betrifft eine Vorrichtung zum Schutz von Halbleitermaterial und ein Verfahren zum Schutz von Halbleitermaterial.

Für die Herstellung von Solarzellen oder elektronischen Bauelementen, wie beispielsweise Speicherelementen oder Mikroprozessoren, wird hochreines Halbleitermaterial benötigt. Man ist daher bestrebt, die Konzentrationen schädlicher Verunreinigungen so niedrig wie möglich zu halten. Häufig wird beobachtet, daß bereits hochrein hergestelltes Halbleitermaterial im Verlauf der weiteren Verarbeitung zu den Zielprodukten erneut kontaminiert wird. So werden immer wieder aufwendige Reinigungsschritte notwendig, um die ursprüngliche Reinheit zurückzuerhalten. Beispielsweise Fremdmetallatome, die in das Kristallgitter des Halbleitermaterials eingebaut werden, stören die Ladungsverteilung und können die Funktion des späteren Bauteils vermindern oder zu dessen Ausfall führen. Infolgedessen sind insbesondere Kontaminationen des Halbleitermaterials durch metallische Verunreinigungen zu vermeiden. Dies gilt insbesondere für Silicium, das in der Elektronikindustrie mit deutlichem Abstand am häufigsten als Halbleitermaterial eingesetzt wird.
Hochreines Silicium erhält man beispielsweise durch thermische Zersetzung leicht flüchtiger und deshalb einfach über Destillationsverfahren zu reinigender Siliciumverbindungen, wie beispielsweise Trichlorsilan.
Zur Herstellung des hochreinen Siliciums nach dem am häufigsten verwendeten Siemens-Verfahren wird in einem Reaktor aus Quarz ein Gemisch Trichlorsilan und Wasserstoff über dünne Siliciumstäbe geleitet, die durch direkten Stromdurchgang auf etwa 1100°C erhitzt werden. Dabei entsteht polykristallines Silicium in Form von Stäben mit typischen Durchmessern von 70 bis 300 mm und Längen von 500 bis 2500 mm an. Das polykristalline Silicium wird zur Produktion von tiegelgezogenen Einkristallen, von Bändern und Folien oder zur Herstellung von polykristallinem Solarzellengrundmaterial verwendet.

Für die Herstellung dieser Produkte ist es notwendig, festes Silicium in Tiegeln aufzuschmelzen. Um einen hohen Füllgrad des Tiegels zu erreichen und so das Aufschmelzen möglichst effektiv zu gestalten, müssen die erwähnten polykristallinen Silicumstäbe, vor dem Aufschmelzen zerkleinert und anschließend klassiert werden. Dies ist üblicherweise immer mit einer oberflächlichen Verunreinigung des Halbleitermaterials verbunden, weil die Zerkleinerung mit metallischen Brechwerkzeugen, wie Backen- oder Walzenbrechern, Hämmern oder Meißeln auf Unterlagen aus Materialien, wie Stahl oder Kunststoff, erfolgt. Auch der anschließende Klassiervorgang findet üblicherweise auf Sieben aus Metall oder Kunststoff statt. Während des Zerkleinerungsvorganges und des Klassierschrittes wird so das Silicium durch Metalle oder Kohlenstoff aus den Werkzeugen und der Unterlage verunreinigt. Zur Beseitigung dieser Kontamination müssen die Bruchstücke vor dem Aufschmelzen einer aufwendigen und kostenintensiven Oberflächenreinigung, wie zum Beispiel durch Ätzen mit HF/HNO₃, unterzogen werden.

Daher werden zur Verminderung der Kontamination beim Zerkleinern auch Siliciumunterlagen und Werkzeuge aus Silicium oder mit Siliciumbeschichtungen verwendet. Auch beim Klassiervorgang sind Siebe aus Silicium oder siliciumbeschichtete Siebe Stand der Technik. Diese haben jedoch den Nachteil, daß sie durch die Übertragung der Kräfte, während des Zerkleinerungsvorgangs (Schlagen mit Hämmern), oder beim Klassiervorgang beschädigt oder zerstört werden und ersetzt werden müssen. Eine Unterlage sowohl'beim Brechen als auch beim Sieben hält im Mittel ca. 10 bis 15 Chargen (entspricht ca. 10 bis 15 t). Anschließend müssen zertrümmerte Stücke (ca. 30 %) ersetzt werden, damit nicht Bruchstücke der Unterlage in das zu verkaufende Material gelangen.

Des weiteren müssen diese Unterlagen aus Silicium entsorgt werden, was weitere Kosten verursacht, da dieses Material rissig ist oder auf unerwünschte Bruchgrößen zerkleinert worden ist und daher nicht mehr verkauft werden kann. Die Herstellung einer solchen Unterlage erfordert zusätzliche Abscheidung von Silicium, mechanische Bearbeitung bei der Herstellung der Formteile und deren aufwendige Reinigung, zum Beispiel durch Ätzen mit HF/HNO₃.

Es ist daher Aufgabe der Erfindung die Nachteile des Standes der Technik zu überwinden und eine Vorrichtung und ein Verfahren zur Verfügung zu stellen, das die zusätzliche Kontamination von Halbleitermaterial beim Zerkleinern, Klassieren oder beim Transport vermindert. Diese Aufgabe wird durch die Erfindung gelöst.

Gegenstand der Erfindung ist eine Vorrichtung zum Schutz von Halbleitermaterial, dadurch gekennzeichnet, daß die Oberfläche eines Trägers eine Oberfläche aus stabilisiertem Eis aus Reinstwasser und Halbleiterpartikeln aufweist.

Bei dem Halbleitermaterial, aus dem die stabilisierte Eisschicht hergestellt ist, handelt es sich vorteilhafterweise um das gleiche, das durch die erfindungsgemäße Vorrichtung geschützt werden soll.

Beispiele für Halbleitermaterialien sind Silicium, Germanium oder Galliumarsenid, wobei Silicium, insbesondere ultrareines Polysilicium, bevorzugt ist.

Die erfindungsgemäße Vorrichtung wird durch stabilisiertes Eis gebildet, das aus Reinstwasser und Partikeln aus Halbleitermaterial hergestellt werden kann. Dieses stabilisierte Eis befindet sich vorzugsweise auf der Oberfläche eines Trägers, wie einer Unterlage aus Stahl, Kunststoff, einem Halbleitermaterial, wie zum Beispiel Silicium oder einem anderen geeigneten Material. Allerdings kann das stabilisierte Eis aus Reinstwasser und Halbleiterpartikeln auch einen selbsttragenden Block bilden.

Dieses stabilisierte Eis wird hergestellt, indem es auf einem Träger, wie einer Unterlage aus Stahl, Kunststoff, einem Halbleitermaterial, wie zum Beispiel vorzugsweise Silicium oder einem anderen geeigneten Material, abgeschieden wird, wobei auf der Unterseite des Trägers Rohre befestigt sind, die von einer Kälteflüssigkeit, wie zum Beispiel vorzugsweise einer wäßrigen Kaliumcarbonat-Lösung, durchströmt werden. Zur besseren Abkühlung des Trägers liegen die Rohre vorzugsweise in einer Wärmeleitpaste. Aus Gründen der Energieeinsparung ist die dem Träger abgewandte Seite der Rohre üblicherweise isoliert. Die Kälteflüssigkeit wird in einer Kältemaschine auf vorzugsweise unter -10°C und besonders bevorzugt auf weniger als -25°C abgekühlt und durch die Rohre des Trägers gepumpt.
Während des Abkühlvorgangs und in der Folgezeit wird die Oberfläche der Unterlage mit Reinstwasser, welches einen spezifischen Leitwert von vorzugsweise kleiner 0,01 µS/cm aufweist, besprüht. Während des Besprühens werden Partikel aus Halbleitermaterial, insbesondere in Form von Staub oder Granulat, kontinuierlich oder völlig diskontinuierlich beliebig, beispielsweise durch Streuen, auf die sich bildende Eisschicht gegeben, wobei die Partikel aus Halbleitermaterial, die auf die sich bildende Eisschicht gegeben werden, vorzugsweise einen Durchmesser von 10 µm bis 5 mm, besonders bevorzugt zwischen 500 µm und 2000 µm, haben.
Ist die Schicht vorzugsweise auf eine Dicke von 0,5 cm bis 30 cm, besonders bevorzugt auf 5 cm bis 20 cm, insbesondere auf 5 cm bis 10 cm angewachsen, wird das zu schützende Halbleitermaterial auf die stabilisierte Eisschicht gelegt. Dieses Halbleitermaterial kann auch auf einen Block aus selbsttragendem Eis aus Reinstwasser und Halbleiterpartikeln gelegt werden oder in diesen eingefroren werden, um es zum Beispiel zu transportieren.

Vorzugsweise liegt bei der erfindungsgemäßen Vorrichtung der Anteil an Halbleiterpartikeln in der Eisschicht zwischen 5 und 70 Gewichtsprozent, besonders bevorzugt zwischen 15 und 35 Gewichtsprozent.

Vorzugsweise wird das Halbleitermaterial, wie beispielsweise nach dem Siemensverfahren erzeugte Siliciumstäbe, auf die stabilisierte Eisschicht gelegt, um auf diesem Eis aus Reinstwasser und Halbleiterpartikeln mit kontaminationationsfreien Brechverfahren, wie beispielsweise mit einem Hammer aus Reinstsilicum, zerkleinert zu werden. Denkbar ist auch ein Zerkleinern zwischen zwei schlagartig zusammenzuschlagenden stabilisierten Eisschichten.
Anschließend wird das entstandene Eis-Silicium-Gemisch mit einem Silicium-Schieber auf eine geheizte Silicium-Unterlage geschoben und mit Strahlungsheizern getrocknet. Nach dem Trocknungsverfahren kann dann beispielsweise das übliche Klassieren auf Siliciumsieben stattfinden. Üblicherweise werden die im Eis enthaltenen Siliciumpartikel von dem im erfindungsgemäßen Brechverfahren zerkleinerten Halbleitermaterial getrennt. Dies kann beispielsweise durch Sieben erfolgen. Die Siliciumpartikel können aber auch mit Luft aus dem Halbleiterprodukt ausgeblasen werden.

Ein weiterer Gegenstand der Erfindung ist eine erfindungsgemäße Vorrichtung zum Schutz von Halbleitermaterial, die dadurch gekennzeichnet ist, daß die Vorrichtung eine Klassiervorrichtung ist.

Des weiteren kann ein Klassiervorgang auf einem mit stabilisiertem Eis aus Reinstwasser und Halbleiterpartikeln beschichteten Sieb stattfinden. Für ein einwandfreies Klassierergebnis ist es allerdings notwendig, daß das stabilisierte Eis aus dem beim Zerkleinern entstandenen Eis-Silicium-Gemisch abgetrennt wird. Das kann beispielsweise durch kurzzeitiges Erwärmen des Gemisches auf einer Siliciumunterlage über den Schmelzpunkt des Wassers erreicht werden. Nach der erfolgten Klassierung findet dann der oben beschriebene Trocknungsvorgang statt. Auch hier werden üblicherweise die im Eis enthaltenen Siliciumpartikel von dem im erfindungsgemäßen Klassierverfahren erhaltenen Halbleitermaterial abgetrennt. Dies kann beispielsweise wiederum durch Sieben erfolgen. Die Siliciumpartikel können aber auch mit Luft aus dem Halbleiterprodukt ausgeblasen werden.

Halbleitermaterial für das bekannte Zonenziehen, wie vorzugsweise Siliciumstäbe, können zur mechanischen Bearbeitung, zum Beispiel Ablängen, Konus anschleifen, in die erfindungsgemäße Vorrichtung eingebettet werden.

Auch Ausbauhilfen zum Ausbauen der Siliciumstäbe aus dem Siemensreaktor können in Form der erfindungsgemäßen Vorrichtung hergestellt und verwendet werden.

Des weiteren kann die erfindungsgemäße Vorrichtung, die auf einer Unterlage aus vorzugsweise Stahl ruht, verwendet werden, um Stäbe aus Silicium kompakt einzubetten und von ihnen die Graphitelektrode zu entfernen, ohne den Stab mit Kohlenstoff zu kontaminieren.

Die erfindungsgemäße Vorrichtung hat den Vorteil, daß das stabilisierte Eis wegen der Durchsetzung der reinen Eisschicht mit bevorzugt ultrareinem Halbleitermaterial eine sehr hohe Standzeit hat, da Spannungen im Vergleich zu einer Eisschicht aus Reinstwasser abgebaut sind.

Ein weiterer Gegenstand der Erfindung ist ein Verfahren zum Schutz von Halbleitermaterial, das eine erfindungsgemäße Vorrichtung verwendet.

Es ist selbstverständlich, daß bei Durchführung des erfindungsgemäßen Verfahrens die stabilisierte Eisschicht gekühlt-wird, um ein Auftauen der Schicht zu verhindern.
Darüberhinaus ist es vorteilhaft, die stabilisierte Eisschicht bei längeren Betriebszeiten kontinuierlich oder diskontinuierlich mit Reinstwasser zu besprühen, um den auftretenden Abrieb zu ersetzen. Bei diesem Regeneriervorgang können, falls erwünscht, Partikel aus Halbleitermaterial zusätzlich zugegeben werden, was jedoch nicht bevorzugt ist, da sich während den Bearbeitungsvorgängen, wie Brechen oder Klassieren, meist von Haus aus feine Halbleiterpartikel bilden, die sich mit dem zur Regeneration verwendeten Wasser niederschlagen.

Bevorzugt ist ein Verfahren zum Schutz von Halbleitermaterial, in der das Halbleitermaterial, vorzugsweise Silicium, zerkleinert wird. Der Vorteil dieser Zerkleinerung auf der erfindungsgemäßen Vorrichtung ist, daß das zu zerkleinernde Material nicht weiter kontaminiert werden kann und die Unterlage zum Zerkleinern leicht von dem Halbleitermaterial getrennt werden kann und entsorgt werden kann, da das stabilisierte Eis aus Reinstwasser und Halbleiterpartikeln einfach geschmolzen wird, was ein überaus umweltfreundliches Verfahren ist. Falls es sich bei dem Träger auf dem sich das stabilisierte Eis befindet, um Silicium handelt ist, ist dies besonders bevorzugt, da falls doch einmal das stabilisierte Eis beschädigt wird, so daß das sich darauf befindende Halbleitermaterial, in Form von Silicium, mit dem Träger in Berührung kommt, das zu zerkleinernde Halbleitermaterial nicht weiter kontaminiert wird.

### Beispiel 1

Auf die Unterseite einer Stahlplatte mit Rahmen (Länge 80 cm, Breite 50 cm; Rahmenhöhe 5 cm) wurden Rohrschlangen aufgeschweißt. Durch diese wurde Kühlsole mit -15°C geleitet, um die Stahlplatte abzukühlen. Durch Aufsprühen von kaltem ReinstWasser (8°C) wurde innerhalb von 75 Minuten eine kompakte Eisschicht von im Mittel 4 cm erzeugt.

Auf dieser Schicht wurden Polysiliciumstäbe mit Durchmesser 135 mm durch Zerschlagen mit einem Silicium-Hammer zerkleinert. Die gewünschte Bruchgröße lag zwischen 40 und 120 mm. Nachdem in 45 Minuten 142 kg Silicium zerkleinert wurden, zeigte die Eisschicht so große Risse, daß eine Kontamination des Polysiliciums durch die Stahlunterlage nicht zu vermeiden war. Daraufhin wurde der Versuch abgebrochen.

Nachdem die Unterlage abgetaut worden war, wurde sie in gleicher Weise abgekühlt. Auf die kalte Stahlplatte wurde dann wieder Reinstwasser aufgesprüht. Jetzt wurden allerdings während des Aufbaus der Eisschicht in insgesamt 5 Schritten 3,5 kg Siliciumgranulat mit einer mittleren Bruchgröße von 952 µm aufgestreut. Nachdem alles Silicium aufgestreut war, wurde weitere 15 Minuten nur Wasser aufgesprüht. Der gesamte Vorgang dauerte diesmal 65 min. Die erreichte Schichtdicke lag im Mittel wieder bei 4 cm.
Auf dieser so erzeugten Schicht wurden Polysiliciumstäbe mit Durchmesser 128 mm wie im ersten Versuch zerkleinert. Erst nach 70 Minuten waren die Risse so groß, daß eine Verunreinigung des Polysiliciums durch die Stahlunterlage nicht auszuschließen war. Bis zu diesem Zeitpunkt waren 232 kg Silicium zerkleinert worden.

## Patentansprüche

1. Vorrichtung zum Schutz von Halbleitermaterial, dadurch gekennzeichnet, daß die Oberfläche eines Trägers eine Oberfläche aus stabilisiertem Eis aus Reinstwasser und Halbleiterpartikeln aufweist.

2. Vorrichtung zum Schutz von Halbleitermaterial nach Anspruch 1, dadurch gekennzeichnet, daß das Halbleitermaterial Silicium ist.

3. Vorrichtung zum Schutz von Halbleitermaterial nach Anspruch 1 oder 2, dadurch gekennzeichnet, daß das zur Herstellung. der Eisfläche verwendete Reinstwasser einen Leitwert von kleiner 0,1 µS/cm hat.

4. Vorrichtung zum Schutz von Halbleitermaterial nach einem oder mehreren der Anspruche 1 bis 3, dadurch gekennzeichnet, daß der Träger aus Silicium besteht.

5. Verfahren zum Schutz von Halbleitermaterial, dadurch gekennzeichnet, daß eine vorrichtung nach einem oder mehreren der Ansprüche 1 bis 4 verwendet wird.

6. Verfahren zum Schutz von Halbleitermaterial nach Anspruch 5, dadurch gekennzeichnet, daß Halbleitermaterial in einer Vorrichtung nach einem oder mehreren der Ansprüche 1 bis 4 zerkleinert wird.

7. Vorrichtung zum Schutz von Halbleitermaterial nach einem oder mehreren der Ansprüche 1 bis 4, dadurch gekennzeichnet, daß die Vorrichtung eine Klassiervorrichtung ist.

8. Verfahren zum Schutz von Halbleitermaterial nach Anspruch 5 oder 6, dadurch gekennzeichnet, daß Halbleitermaterial in einer Vorrichtung nach Anspruch 7 klassiert wird.

## Claims

1. Device for protecting semiconductor material, characterized in that the surface of a support has a surface of stabilized ice made from ultrapure water and semiconductor particles.

2. Device for protecting semiconductor material according to Claim 1, characterized in that the semiconductor material is silicon.

3. Device for protecting semiconductor material according to Claim 1 or 2, characterized in that the ultrapure water used to produce the ice surface has a conductance of less than 0.1 µS/cm.

4. Device for protecting semiconductor material according to one or more of Claims 1 to 3, characterized in that the support consists of silicon.

5. Method for protecting semiconductor material, characterized in that the device according to one or more of Claims 1 to 4 is used.

6. Method for protecting semiconductor material according to Claim 5, characterized in that semiconductor material is comminuted in the device according to one or more of Claims 1 to 4.

7. Device for protecting semiconductor material according to one or more of Claims 1 to 4, characterized in that the device is a classification device.

8. Method for protecting semiconductor material according to Claim 5 or 6, characterized in that semiconductor material is classified in the device according to Claim 7.

## Revendications

1. Dispositif pour la protection de matériau semi-conducteur, caractérisé en ce que la surface d'un support présente une surface constituée de glace stabilisée à partir d'eau extra pure, et de particules semi-conductrices.

2. Dispositif pour la protection de matériau semi-conducteur selon la revendication 1, caractérisé en ce que le matériau semi-conducteur est le silicium.

3. Dispositif pour la protection de matériau semi-conducteur selon les revendications 1 ou 2, caractérisé en ce que l'eau extra pure utilisée pour la production de la surface de glace présente une conductivité inférieure à 0,1 µS/cm.

4. Dispositif pour la protection de matériau semi-conducteur selon l'une ou plusieurs des revendications 1 à 3, caractérisé en ce que le support est constitué de silicium.

5. Procédé pour la protection de matériau semi-conducteur, caractérisé en ce qu'on utilise un dispositif selon l'une ou plusieurs des revendications 1 à 4.

6. Procédé pour la protection de matériau semi-conducteur selon la revendication 5, caractérisé en ce que le matériau semi-conducteur est fragmenté dans un dispositif selon l'une ou plusieurs des revendications 1 à 4.

7. Dispositif pour la protection de matériau semi-conducteur selon l'une ou plusieurs des revendications 1 à 4, caractérisé en ce que le dispositif est un dispositif de classification.

8. Procédé pour la protection de matériau semi-conducteur selon la revendication 5 ou 6, caractérisé en ce que le matériau semi-conducteur est classé dans un dispositif selon la revendication 7.
